# FASCICULE DE BREVET EUROPEEN

(11) **EP 2 415 078 B1**
(45) Date de publication et mention de la délivrance du brevet: **15.01.2014**
(21) Numéro de dépôt: 10723185.4
(22) Date de dépôt: 01.04.2010
(51) Int. Cl.: H01L 27/146, G01T 1/24, H01J 31/49, H01L 31/0224

(54) **DISPOSITIF DE DETECTION D'IMAGE ELECTRONIQUE**
ELEKTRONISCHE BILDDETEKTIONSEINRICHTUNG
ELECTRONIC IMAGE DETECTION DEVICE

(30) Priorité: 02.04.2009 FR 0952111
(43) Date de publication de la demande: 08.02.2012
(73) Titulaire: Commissariat à l'Énergie Atomique et aux Énergies Alternatives, 75015 Paris (FR)
(72) Inventeur: GIFFARD, Benoît, F-38000 Grenoble (FR); CAZAUX, Yvon, F-38100 Grenoble (FR)
(74) Mandataire: de Beaumont, Michel
(86) Numéro de dépôt international: PCT/FR2010/050629
(87) Numéro de publication internationale: WO 2010/112783

(56) Documents cités:
- EP-A- 0 527 373
- WO-A-98/50955
- WO-A-02/071497
- DE-A1- 19 944 731
- FR-A- 2 888 667
- FR-A1- 2 848 027
- US-A1- 2004 178 416
- US-A1- 2008 258 189
- US-B1- 7 034 333
- PATENT ABSTRACTS OF JAPAN vol. PAJ, 2 mai 1985 (1985-05-02) -& JP 60 077472 A (FUJI PHOTO FILM CO LTD), 2 mai 1985 (1985-05-02)

## Description

### Domaine de l'invention

La présente invention concerne un dispositif de détection d'image électronique.

### Exposé de l'art antérieur

Pour faire de la détection d'image, il est connu d'utiliser la technologie CMOS et de former, dans un substrat semiconducteur, des pixels comprenant des photodiodes associées à des transistors, par exemple de précharge et de lecture. Les photons incidents génèrent des paires électrons/trous et les électrons de ces paires sont collectés par les photodiodes. Les électrons sont alors convertis en tension à l'intérieur du pixel avant d'être lus à l'aide d'un circuit électronique de lecture situé en périphérie d'une matrice de pixels.

Dans le cas de capteurs d'image destinés à la vision nocturne ou par faible luminosité, il est connu de réaliser la détection non pas sur une image optique mais sur une image électronique associée. Pour cela, l'image optique est transformée en image électronique par un convertisseur photons/électrons, encore appelé photocathode, qui délivre une matrice de faisceaux d'électrons. Pour augmenter la sensibilité globale du capteur, on peut prévoir, en sortie de la photocathode, un amplificateur d'électrons qui fournit une image électronique amplifiée en direction d'un dispositif de détection d'image électronique.

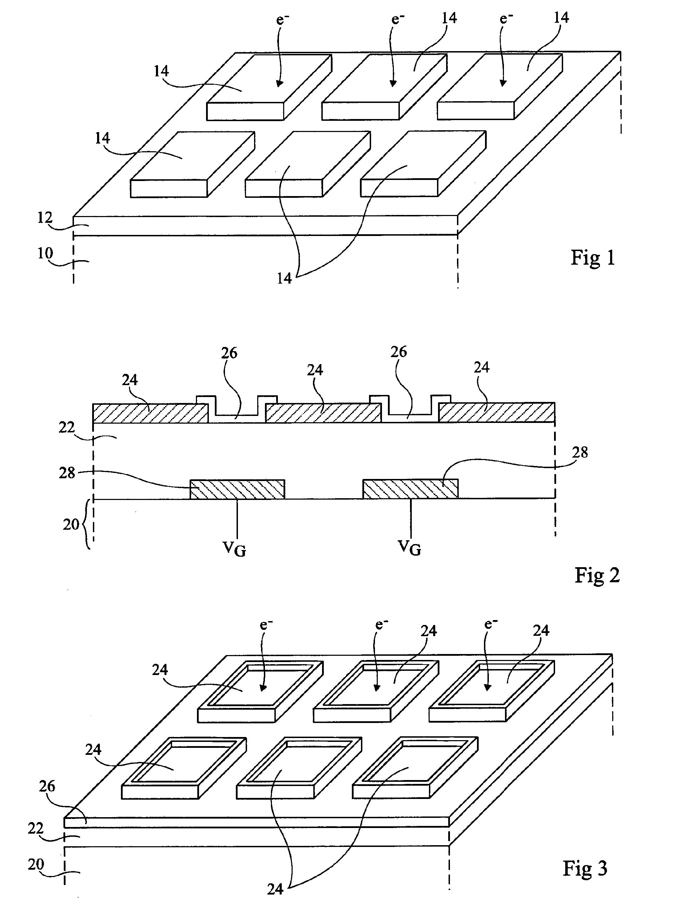

La figure 1 est une vue en perspective simplifiée d'un dispositif de détection d'image électronique.

Sur un support 10 s'étend une couche isolante 12. Le support 10 est constitué par exemple d'un substrat semiconducteur comportant des dispositifs actifs (transistors et diodes) d'un circuit intégré CMOS sur lequel est formé un empilement de niveaux d'interconnexion reliant ces dispositifs actifs. La couche isolante 12 peut constituer une partie du dernier niveau de l'empilement d'interconnexion. Sur la couche isolante 12 s'étendent des électrodes métalliques 14 qui sont disposées, dans l'exemple représenté, sous forme de matrice. Chaque électrode 14 est connectée à un élément du circuit intégré formé dans le substrat semiconducteur par des pistes et des vias prévus dans l'empilement de niveaux d'interconnexion (non représentés). Des électrons arrivant en surface du dispositif de la figure 1 sont captés par les électrodes métalliques 14 puis sont transférés vers le circuit intégré pour traitement et lecture. Ainsi, en plus des éléments prévus dans le pixel de façon classique, chaque pixel du dispositif de détection d'image électronique comprend une électrode métallique 14 et des pistes et vias métalliques de connexion au circuit intégré.

Lorsque des électrons atteignent des portions de la couche isolante 12 non protégées par une électrode métallique 14, ils génèrent, dans l'isolant, une charge électrique piégée qui peut influer sur la qualité de l'image et, éventuellement, provoquer des claquages électriques. Les charges stockées dans le matériau isolant forment un champ électrique qui peut dévier des électrons incidents, entraînant une perturbation de l'image. Pour éviter que des électrons n'atteignent le matériau diélectrique 12, il a été proposé de graver le matériau diélectrique autour des électrodes métalliques 14 et de découvrir ainsi, au fond des emplacements gravés, une couche métallique. Cette couche métallique forme une barrière à la pénétration des électrons dans le matériau isolant 12 et est reliée électriquement au circuit CMOS, ce qui permet d'évacuer les charges électroniques collectées. On peut également prévoir une structure dans laquelle les électrodes métalliques 14 sont en contrebas par rapport à une couche métallique de protection supérieure.

Une structure étagée telle que présentée ci-dessus pose deux problèmes. Le premier est que la structure obtenue présente une surface supérieure qui n'est pas plane. Ceci interdit ou rend très difficile tout procédé ultérieur de fabrication, par exemple de formation de plots de connexion permettant des reprises de contact sur le substrat. De plus, des électrons peuvent se réfléchir sur des portions métalliques inférieures et atteindre le matériau isolant de la couche 12, par le côté des marches de la structure. Ainsi, des électrons peuvent générer dans cette couche isolante une charge électrique piégée et conduire malgré tout à des claquages électriques et à des perturbations de l'image.

On connaît également les documents US2008258189, FR 2 888 667, WO 02/071497, US 7 034 333, DE 199 44 731, JP 60 07472 et FR 2 848 027 qui prévoient des dispositifs de détection d'image présentant leurs inconvénients propres.

Il existe donc un besoin d'un dispositif de détection d'image électronique dont la surface supérieure est plane et qui évite le piégeage d'électrons et la dégradation du matériau diélectrique présent sous et/ou entre les électrodes métalliques.

### Résumé

Un objet de la présente invention est de prévoir un dispositif de détection d'image électronique selon la revendication 1 dans lequel le matériau isolant entre les électrodes métalliques des pixels est protégé des électrons incidents.

Un autre objet de la présente invention est de prévoir un dispositif de détection d'image électronique susceptible de présenter une surface supérieure plus plane que celle des dispositifs de détection d'image de l'art antérieur.

Selon un mode de réalisation de la présente invention, le silicium amorphe est hydrogéné.

Selon un mode de réalisation de la présente invention, des tranchées sont formées dans la couche isolante entre les électrodes métalliques.

Selon un mode de réalisation de la présente invention, au moins une électrode de grille est prévue sur une seconde face de la couche isolante, en regard d'au moins une région de silicium amorphe, ladite au moins une électrode de grille étant adaptée à être connectée à une source de tension de polarisation.

Selon un mode de réalisation de la présente invention, l'électrode de grille s'étend partiellement en regard des électrodes métalliques.

Selon un mode de réalisation de la présente invention, le silicium amorphe a une épaisseur comprise entre 2 et 500 nm, de préférence entre 10 et 100 nm.

Selon un mode de réalisation de la présente invention, les électrodes métalliques sont séparées d'une distance d'environ 1 µm.

Selon un mode de réalisation de la présente invention, les électrodes métalliques sont en aluminium.

Selon un mode de réalisation de la présente invention, la couche isolante est en contact, du côté de sa seconde face, avec un support constitué d'un empilement de niveaux d'inter-connexion s'étendant sur un substrat semiconducteur.

Selon un mode de réalisation de la présente invention, les électrodes métalliques sont reliées par des vias conducteurs, formés dans l'empilement d'interconnexion, à des composants électroniques formés dans le substrat semiconducteur.

Un mode de réalisation de la présente invention prévoit en outre un capteur d'image comprenant une photocathode, une galette de microcanaux et un dispositif de détection d'image électronique tel que ci-dessus.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, est une vue en perspective simplifiée d'un dispositif de détection d'image électronique classique ;
la figure 2 est une vue en coupe d'un dispositif de détection d'image électronique selon un mode de réalisation de la présente invention ;
la figure 3 est une vue en perspective d'un dispositif de détection d'image électronique selon un mode de réalisation de la présente invention ;
la figure 4 est une vue en perspective d'un dispositif de détection d'image électronique selon une variante d'un mode de réalisation de la présente invention ;
la figure 5 est une vue en coupe d'un dispositif de détection d'image électronique selon un exemple ne faisant pas partie de la présente invention ;
la figure 6 est une vue en coupe d'un dispositif de détection d'image électronique selon une autre variante d'un mode de réalisation de la présente invention ;
la figure 7 est une vue en coupe d'un dispositif de détection d'image électronique selon un exemple ne faisant pas partie de la présente invention ;
la figure 8 est une vue en coupe illustrant partiellement un exemple de connexion entre les éléments d'un dispositif de détection selon un mode de réalisation de la présente invention et des éléments formés dans un substrat semiconducteur inférieur ; et
la figure 9 est un schéma sous forme de blocs illustrant un ensemble capteur d'image comprenant un dispositif de détection d'image électronique.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

Les figures 2 et 3 sont des vues, respectivement en coupe et en perspective, d'un mode de réalisation d'un dispositif de détection d'image électronique.

Le dispositif de détection est formé sur un support 20 constitué d'un empilement de niveaux d'interconnexion s'étendant sur un substrat semiconducteur. Des composants électroniques permettant le traitement de l'image électronique détectée sont formés dans le substrat et sont connectés au dispositif de détection par des pistes et vias conducteurs formés dans l'empilement d'interconnexion.

Une couche isolante 22 s'étend sur le support 20 et des électrodes métalliques 24 sont formées en surface de la couche isolante 22. Chaque électrode métallique 24 correspond à un pixel du dispositif de détection. La couche isolante 22 et les électrodes métalliques 24 peuvent être formées de la même façon que les niveaux d'interconnexion inférieurs et donc constituer le dernier niveau de l'empilement d'interconnexion du support 20. A titre d'exemple, la couche isolante 22 peut être en oxyde de silicium et les électrodes métalliques 24 peuvent être en aluminium. Également à titre d'exemple, les électrodes métalliques 24 peuvent être réparties sous forme de matrice en surface de la couche isolante 22.

Selon un mode de réalisation, des régions 26 constituées de silicium amorphe s'étendent, sur la couche isolante 22 entre deux électrodes métalliques 24 adjacentes. Les régions 26 recouvrent toute la surface de la couche isolante non recouverte par les électrodes métalliques 24 pour protéger les portions apparentes de la couche isolante 22 des électrons incidents. En vue de dessus, les régions 26 se rejoignent pour entourer chaque électrode 24. Les régions 26 atteignent les électrodes 24 et s'étendent sur les parois et sur les bords des électrodes métalliques 24 en formant ainsi un quadrillage des électrodes.

Le silicium amorphe est à l'état quasi intrinsèque, de façon à être fortement isolant et à avoir une résistivité volumique supérieure à 10⁹ Ω.cm à température ambiante. Ainsi, la résistance de fuite entre deux électrodes de deux pixels voisins est très élevée. Le silicium amorphe étant un semiconducteur, il autorise cependant le transfert d'électrons atteignant une région de silicium amorphe 26 vers l'électrode métallique 24 la plus proche. Le signal collecté entre les électrodes 24 contribue ainsi au signal utile détecté par les pixels.

De préférence, le silicium amorphe est hydrogéné pour avoir une résistivité volumique supérieure à celle du silicium amorphe simple, de l'ordre de 10¹⁰ Ω.cm. Il peut être formé à des températures faibles, typiquement inférieures à 400°C, qui sont compatibles avec la présence de composants électroniques finis dans le substrat semiconducteur inférieur (pas de dégradation de ces composants).

Le silicium amorphe hydrogéné a une tendance naturelle à être légèrement de type N. Pour éviter que cette propriété n'influe sur le caractère isolant des régions de silicium 26 et pour contrôler la conductivité de la couche de silicium amorphe, le dispositif de la figure 2 peut comprendre une électrode de grille 28 formée à la jonction entre le support 20 et la couche isolante 22. L'électrode 28 s'étend en regard des régions situées entre les électrodes et, de préférence, sur une surface légèrement plus étendue que l'espace inter-électrode (c'est-à-dire légèrement en regard des électrodes métalliques 24). L'électrode 28 est connectée à une source de tension de polarisation V_{G} qui permet, du fait de l'empilement métal/isolant/semiconducteur (28/22/26), de dépléter les régions de silicium amorphe hydrogéné 26. On évite ainsi l'apparition d'un canal de conduction dans le semiconducteur qui provoquerait un passage de charges électriques trop important entre deux électrodes métalliques 24 adjacentes. On notera que l'électrode 28 peut être formée en même temps que des pistes conductrices présentes dans l'avant-dernier niveau d'interconnexion de l'empilement d'interconnexion.

A titre d'exemple de valeurs numériques, le silicium amorphe hydrogéné 26 peut avoir une épaisseur comprise entre 2 et 500 nm, de préférence entre 10 et 100 nm, et les électrodes métalliques 24 peuvent être séparées d'une distance de l'ordre de 1 µm.

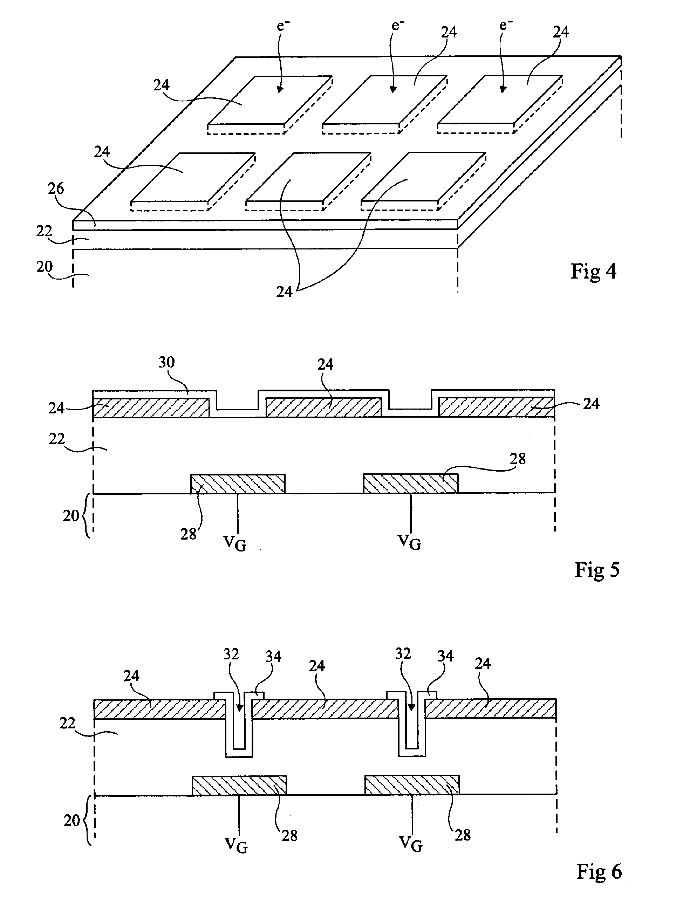

La figure 4 est une vue en perspective d'un exemple de réalisation dans laquelle la couche de silicium amorphe 26 s'étend autour des électrodes 24 et présente une épaisseur du même ordre que celle des électrodes 24. Ainsi, la structure obtenue est plane ou quasi plane.

La figure 5 illustre un exemple de réalisation dans laquelle les régions 26 de silicium amorphe sont remplacées par une couche de silicium amorphe 30 qui s'étend sur la couche isolante 22 et sur les électrodes 24. Ainsi, en vue de dessus, le silicium amorphe 30 forme une couche conformée sans ouverture sur la matrice d'électrodes. Les électrons atteignant la couche de silicium amorphe 30 sont transportés par celle-ci vers les électrodes métalliques 24 sous-jacentes, le silicium amorphe 30 assurant avantageusement l'isolement entre deux électrodes métalliques 24 voisines. Une électrode de grille 28, formée à la jonction entre le support 20 et la couche isolante 22 et connectée à une source de tension de polarisation V_{G}, peut aider à cet isolement, comme décrit ci-dessus.

La figure 6 illustre une autre variante de réalisation. Pour isoler deux électrodes 24 adjacentes, des zones 32 de la couche isolante 22, entre les électrodes 24, sont gravées. Des régions 34 de silicium amorphe s'étendent entre les électrodes métalliques 24 en suivant la zone gravée 32. Dans cette variante, les électrodes métalliques 24 sont susceptibles d'être plus rapprochées les unes des autres que dans les variantes précédemment décrites, l'isolement par de l'air dans les zones gravées 32 permettant d'éviter des interférences entre deux électrodes 24 voisines.

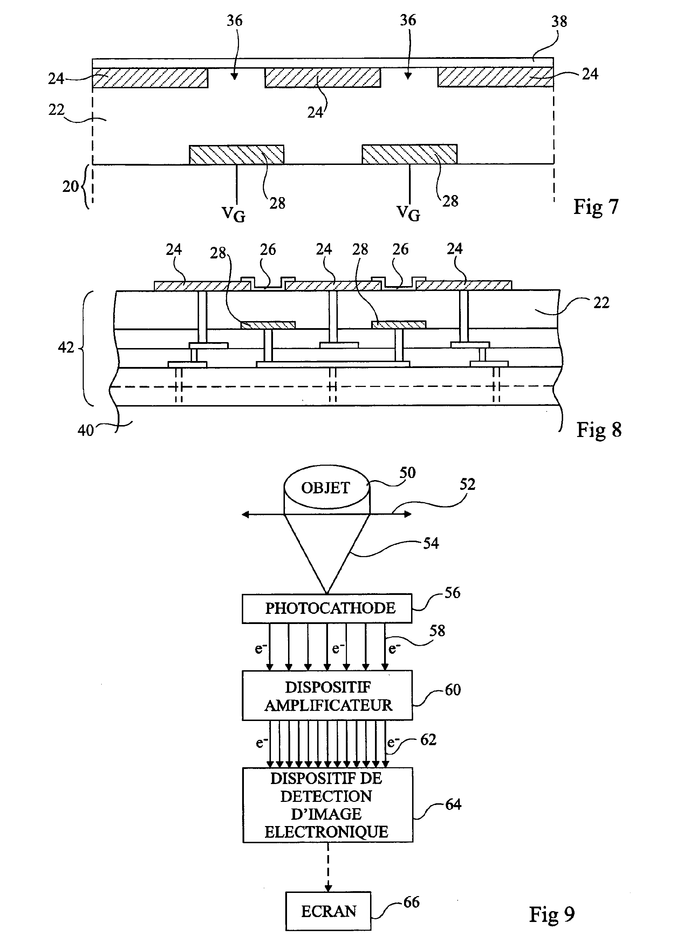

La figure 7 illustre un exemple de réalisation dans laquelle la surface supérieure du dispositif est plane. Pour ce faire, l'espace inter-électrodes est comblé par des régions isolantes 36, par exemple en un matériau identique à celui de la couche 22. Une couche de silicium amorphe 38 est déposée uniformément sur toute la surface plane ainsi obtenue. De la même façon que dans la variante de la figure 5, les électrons atteignant la couche de silicium amorphe 38 sont transportés par celle-ci vers les électrodes métalliques 24, le silicium amorphe 38 assurant également l'isolement entre deux électrodes métalliques 24 voisines.

On notera que les variantes des figures 2-3, 4 et 6 seront préférées aux exemples des figures 5 et 7 en raison de leur stabilité dans le temps. Dans ces deux variantes, le silicium amorphe ne recouvre pas l'ensemble du dispositif mais est présent uniquement entre les électrodes adjacences, au-dessus de la couche isolante 22, pour protéger la couche isolante des électrons incidents. En effet, la présence de la couche de silicium amorphe 30, 38 au-dessus des électrodes métalliques 24, bien qu'elle n'influe pas sur la détection d'électrons par la face supérieure du dispositif, peut provoquer une accumulation de quelques électrons au-dessus des électrodes, et donc la formation d'une charge fluctuante dans la couche de silicium amorphe, ce qui peut avoir un impact sur la qualité de l'image obtenue. De plus, dans le cas où un flux de photons incidents est présent, un courant électrique parasite peut être généré sur les électrodes 24 du fait du comportement photogénérateur du silicium amorphe.

Pour obtenir les structures des figures 2 et 3, on pourra par exemple réaliser les étapes suivantes : former, sur une structure telle que celle de la figure 1, une couche continue de silicium amorphe par un dépôt par plasma sous vide de silane, à une température inférieure à 200°C ; réaliser une lithographie, à l'aide d'un masque adapté, de la couche de silicium amorphe formée ; et graver la couche de silicium amorphe pour découvrir les électrodes métalliques 24, au moins dans leurs régions centrales. Pour obtenir la structure de la figure 6, la couche isolante 22 sera gravée au préalable au niveau des régions désirées de silicium amorphe.

Pour obtenir la structure de la figure 4, on pourra par exemple réaliser les étapes suivantes : former, sur une structure telle que celle de la figure 1, une couche continue de silicium amorphe par un dépôt par plasma sous vide de silane, à une température inférieure à 200°C ; et réaliser un polissage mécano-chimique sélectif de la couche de silicium amorphe par rapport aux électrodes métalliques pour découvrir la surface supérieure des électrodes métalliques 24. Ainsi, la couche de silicium amorphe obtenue peut avoir une épaisseur sensiblement égale à celle des électrodes métalliques 24 ou légèrement inférieure à celle des électrodes métalliques 24.

La figure 8 est une vue en coupe illustrant partiellement un exemple de connexions possibles entre le dispositif de détection d'image électronique des figures 2 et 3 et des éléments formés dans un substrat semiconducteur inférieur.

En figure 8, le support 20 est représenté plus en détail. Le support comprend un substrat de silicium 40 en surface duquel est formé un empilement de niveaux d'interconnexion 42, la couche isolante 22 et les électrodes 24 en formant le dernier niveau. Chaque niveau d'interconnexion comprend des pistes métalliques qui peuvent être connectées entre elles par des vias métalliques. Dans l'exemple représenté, chaque électrode métallique 24 est connectée à des composants formés dans le substrat 40 (non représentés) par l'intermédiaire de vias et de pistes métalliques de l'empilement 42, et les électrodes de grille 28 sont connectées entre elles, et à une tension de polarisation, également par l'intermédiaire de pistes et de vias de l'empilement 42. On notera que l'électrode de grille pourra être constituée d'une unique région métallique et être connectée, par une unique connexion, à la source de tension de polarisation V_{G}.

La figure 9 illustre, sous forme de blocs, un ensemble capteur d'image comprenant un dispositif de détection d'image électronique.

L'ensemble capteur d'image est destiné à réaliser l'image d'un objet 50. L'image photonique 54 de l'objet 50, obtenue par l'intermédiaire d'un dispositif optique 52 comprenant par exemple une lentille, est transformée par une photocathode 56 en une image électronique 58. Cette image électronique est transmise à un dispositif amplificateur 60, par exemple une galette de microcanaux (ou MCP, de l'acronyme anglais "micro channel plate"). L'image amplifiée 62 fournie par le dispositif amplificateur 60 est détectée par un dispositif détection d'image électronique 64 tel que présenté ici. Optionnellement, un écran 66 peut être prévu pour afficher l'image détectée par le dispositif de détection d'image électronique 64.

Des modes de réalisation particuliers de la présente invention ont été décrits. Diverses variantes et modifications apparaîtront à l'homme de l'art. En particulier, on notera que les applications numériques données ici ne le sont qu'à titre d'exemple. De plus, le dispositif de détection d'image électronique présenté ici pourra être utilisé dans tout système nécessitant la détection d'une image électronique, différent de celui présenté en relation avec la figure 9. De plus, en relation avec chacune des variantes de la présente invention, on a précisé que les régions de silicium amorphe situées entre les électrodes 24 permettent de collecter les électrons incidents puis de les transporter vers des électrodes adjacentes. On notera que l'on pourra également prévoir, dans la couche isolante sous-jacente à ces régions, des pistes et vias conducteurs permettant d'évacuer ces électrons collectés, par exemple vers un substrat inférieur.

## Revendications

1. Dispositif de détection d'image électronique, comprenant :
une pluralité d'électrodes métalliques (24) sur une première face d'une couche isolante (22) ; et
des régions de silicium amorphe (26, 34) s'étendant sur la couche isolante entre les électrodes métalliques, les régions de silicium amorphe (26, 34) s'étendant sur la couche isolante entre les électrodes métalliques pour recouvrir toute la surface de la couche isolante non recouverte par les électrodes métalliques (24) et s'étendant sur les parois des électrodes (24), **caractérisé en ce que** les régions de silicium amorphe (26, 34) ne recouvrent pas éntièrement la surface supérieure des électrodes métalliques (24) et **en ce que** le silicium amorphe (26, 34) présente une résistivité volumique supérieure à 10⁹Ω. cm.

2. Dispositif selon la revendication 1, dans lequel le silicium amorphe (26, 34) est hydrogéné.

3. Dispositif selon la revendication 1 ou 2, dans lequel des tranchées (32) sont formées dans la couche isolante (12) entre les électrodes métalliques.

4. Dispositif selon l'une quelconque des revendications 1 à 3, dans lequel au moins une électrode de grille (28) est prévue sur une seconde face de la couche isolante (22), en regard d'au moins une région de silicium amorphe, ladite au moins une électrode de grille étant adaptée à être connectée à une source de tension de polarisation (V_{G}).

5. Dispositif selon la revendication 4, dans lequel l'électrode de grille (28) s'étend partiellement en regard des électrodes métalliques (24).

6. Dispositif selon l'une quelconque des revendications 1 à 5, dans lequel le silicium amorphe (26, 34) a une épaisseur comprise entre 2 et 500 nm, de préférence entre 10 et 100 nm.

7. Dispositif selon l'une quelconque des revendications 1 à 6, dans lequel les électrodes métalliques (24) sont séparées d'une distance d'environ 1 µm.

8. Dispositif selon l'une quelconque des revendications 1 à 7, dans lequel les électrodes métalliques (24) sont en aluminium.

9. Dispositif selon l'une quelconque des revendications 1 à 8, dans lequel la couche isolante (22) est en contact, du côté de sa seconde face, avec un support (20) constitué d'un empilement de niveaux d'interconnexion (42) s'étendant sur un substrat semiconducteur (40).

10. Dispositif selon la revendication 9, dans lequel les électrodes métalliques (24) sont reliées par des vias conducteurs, formés dans l'empilement d'interconnexion (42), à des composants électroniques formés dans le substrat semi-conducteur (40).

11. Capteur d'image comprenant une photocathode (56), une galette de microcanaux (60) et un dispositif de détection d'image électronique (64) selon l'une quelconque des revendications 1 à 10.

## Patentansprüche

1. Eine elektronische Bilddetektionsvorrichtung, die Folgendes aufweist:
eine Vielzahl von Metallelektroden (24) auf einer ersten Oberfläche einer Isolierschicht (22); und
amorphe Siliziumzonen (26, 34), die sich auf der Isolierschicht zwischen den Metallelektroden erstrecken, wobei sich die amorphen Siliziumzonen (26, 34) über die Isolierschicht zwischen den Metallelektroden erstrecken, um die ganze Oberfläche der Isolierschicht, die nicht durch die Metallelektroden (24) abgedeckt ist, abzudecken, und sich ferner auf den Wänden der Elektroden (24) erstrecken, **dadurch gekennzeichnet, dass** die amorphen Siliziumzonen (26, 34) die Oberfläche der Metallelektroden (24) nicht vollständig abdecken und dass das amorphe Silizium (26, 34) einen Volumenwiderstandswert (spezifischer Durchgangswiderstand) hat, der größer ist als 10⁹ Ω x cm.

2. Die Vorrichtung nach Anspruch 1, wobei das amorphe Silizium (26, 34) hydriert ist.

3. Die Vorrichtung nach Anspruch 1 oder 2, wobei Gräben (32) in der Isolierschicht (12) zwischen den Metallelektroden gebildet sind.

4. Die Vorrichtung nach einem der Ansprüche 1 bis 3, wobei mindestens eine Gate-Elektrode (28) auf einer zweiten Oberfläche der Isolierschicht (22) vorgesehen ist und zwar vor der mindestens einen amorphen Siliziumzone, wobei die erwähnte mindestens eine Gate-Elektrode in der Lage ist mit einer Vorspannungsquelle (V_{G}) verbunden zu werden.

5. Die Vorrichtung nach Anspruch 4, wobei die Gate-Elektrode (28) sich teilweise vor den Metallelektroden (24) erstreckt.

6. Die Vorrichtung nach einem der Ansprüche 1 bis 5, wobei das amorphe Silizium (26, 34) eine Dicke im Bereich zwischen 2 und 500 nm, vorzugsweise zwischen 10 und 100 nm, besitzt.

7. Die Vorrichtung nach einem der Ansprüche 1 bis 6, wobei die Metallelektroden (24) durch einen Abstand von ungefähr 1 µm voneinander getrennt sind.

8. Die Vorrichtung nach einem der Ansprüche 1 bis 7, wobei die Metallelektroden (24) aus Aluminium hergestellt sind.

9. Die Vorrichtung nach einem der Ansprüche 1 bis 8, wobei die Isolierschicht (22) auf der Seite ihrer zweiten Oberfläche in Kontakt mit einem Träger (20) ist, geformt aus einem Stapel von miteinander verbundenen Niveaus (42), die sich auf einem Halbleitersubstrat (40) erstrecken.

10. Die Vorrichtung nach Anspruch 9, wobei die Metallelektroden (24) mit leitenden Vias verbunden sind, und zwar geformt in dem Zwischenverbindungsstapel (42) und zwar zu elektronischen Komponenten, geformt in dem Halbleitersubstrat (40).

11. Ein Bildsensor, der eine Fotokathode (56), eine Mikrokanalplatte (60) und die elektronische Bilddetektionsvorrichtung (64) nach einem der Ansprüche 1 bis 10 aufweist.

## Claims

1. An electronic image detection device, comprising:
a plurality of metal electrodes (24) on a first surface of an insulating layer (22); and
amorphous silicon regions (26, 34) extending on the insulating layer between the metal electrodes, the amorphous silicon regions (26, 34) extending over the insulating layer between the metal electrodes to cover all the surface of the insulating layer not covered by the metal electrodes (24) and extending on the walls of the electrodes (24), **characterized in that** the amorphous silicon regions (26, 34) do not fully cover the upper surface of the metal electrodes (24), and **in that** the amorphous silicon (26, 34) has a volume resistivity greater than 10⁹ Ω.cm.

2. The device of claim 1, wherein the amorphous silicon (26, 34) is hydrogenated.

3. The device of claim 1 or 2, wherein trenches (32) are formed in the insulating layer (12) between the metal electrodes.

4. The device of any of claims 1 to 3, wherein at least one gate electrode (28) is provided on a second surface of the insulating layer (22), in front of at least one amorphous silicon region, said at least one gate electrode being capable of being connected to a bias voltage source (V_{G}).

5. The device of claim 4, wherein the gate electrode (28) extends partially in front of the metal electrodes (24).

6. The device of any of claims 1 to 5, wherein the amorphous silicon (26, 34) has a thickness ranging between 2 and 500 nm, preferably between 10 and 100 nm.

7. The device of any of claims 1 to 6, wherein the metal electrodes (24) are separated by a distance of approximately 1 µm.

8. The device of any of claims 1 to 7, wherein the metal electrodes (24) are made of aluminum.

9. The device of any of claims 1 to 8, wherein the insulating layer (22) is in contact, on the side of its second surface, with a support (20) formed of a stack of interconnection levels (42) extending on a semiconductor substrate (40).

10. The device of claim 9, wherein the metal electrodes (24) are connected by conductive vias, formed in the interconnection stack (42), to electronic components formed in the semiconductor substrate (40).

11. An image sensor comprising a photocathode (56), a microchannel plate (60), and the electronic image detection device (64) of any of claims 1 to 10.
